# EUROPEAN PATENT APPLICATION

(11) **EP 0 704 886 A1**
(43) Date of publication of application: **03.04.1996**
(21) Application number: 94830463.9
(22) Date of filing: 29.09.1994
(51) Int. Cl.: H01L 21/321

(54) **Process for etching cobalt silicide layers**

(71) Applicant: CONSORZIO PER LA RICERCA SULLA MICROELETTRONICA NEL MEZZOGIORNO, I-95121 Catania (IT)
(72) Inventor: Rapisarda, Cirino, I-95032 Belpasso (Catania) (IT)
(74) Representative: Mittler, Enrico

(57) **Abstract**

A process for etching a cobalt silicide layer (15), superimposed over a polysilicon layer (14) formed over a silicon substrate (12), and selectively covered by a masking material (16), provides for: submitting the cobalt silicide layer (15) to a flow of gaseous chlorine at a prescribed pressure; ionizing the gaseous chlorine by using a prescribed electrical power to form a plasma for selectively removing the cobalt silicide layer (15).

## Description

The present invention relates to a process for etching cobalt silicide layers.

It is known that in microelectronics polysilicon is used to provide additional layers of electrical interconnections.

Polysilicon, however, is not as good an electrical conductor as aluminium, hence interconnections made of polysilicon must be relatively short.

One known technique for reducing the relatively high resistivity of polysilicon provides for forming a silicide layer over the polysilicon layer; thanks to the low resistivity of silicides, the overall sheet resistance of the silicide/polysilicon layer is low, and it is thus possible to form low-resistance long interconnections. In this way, it is possibile to reduce the physical dimensions of the devices and to increase their performances.

Silicide can be obtained by Chemical Vapor Deposition (WSi2) or synthesized by thermal treatment of the relative refractory metal sputtered on polysilicon layers. In the first case a blanket film is formed anywhere on the wafer and subsequently patterned in order to obtain the desired structures. In the second case the silicide is formed only on the silicon region uncovered by silicon dioxide (Self-Aligned applications). In some particular applications it is necessary to form self-aligned silicide and furthermore to pattern it (double level polysilicon bipolar transistors).

In this cases, cobalt silicide (CoSi₂) and titanium silicide (TiSi₂) are the most promising materials, because they have a lower resistivity and a higher thermal stability compared to other silicides; furthermore, they can be formed by means of self-aligned processes.

Cobalt silicide has a number of advantages with respect to titanium silicide. While in fact the formation of a layer of titanium silicide with low resistivity (phase C54) is prevented by high concentrations of N type dopants in silicon, cobalt silicide is much less sensitive to the dopant concentration. Furthermore, cobalt silicide is more resistant than titanium silicide to solutions containing hidrofluoric acid.

After the polysilicon and silicide layers has been formed, they must be selectively removed to form the desired pattern of interconnections; if the geometries to be defined are small, a dry etching technique must be used. The etching process must be highly selective with respect to the photoresist which provides the litographic mask, and it must also be anisotropic, to allow a fine dimensional control.

The problem is that up to now, no etching processes have proven suitable for cobalt silicide layers.

In view of the state of the art described, it is an object of the present invention to provide a process for etching a cobalt silicide layer which allows to define small geometries.

According to the present invention, such an object is achieved by means of a process for etching a cobalt silicide layer, superimposed over a polysilicon layer formed over a silicon substrate, and selectively covered by a masking material, characterized by submitting the cobalt silicide layer to a flow of gaseous chlorine at a prescribed pressure, and ionizing the gaseous chlorine by using a prescribed electrical power to form a plasma for selectively removing the cobalt silicide layer.

Thanks to the present invention, a process is provided for dry etching cobalt silicide layers; the etching process according to the present invention is selective with respect to the masking material (photoresist), and is also anisotropic, to allow a fine control of the geometries to be defined in the cobalt silicide layers.

These and other features of the present invention will be made more evident by the following detailed description of one particular embodiment, described as a non-limiting example in the annexed drawings, wherein:
Figure 1 is a cross-sectional view of a part of a silicon wafer with a cobalt silicide layer superimposed over a polysilicon layer, before the process according to the present invention has been performed;
Figure 2 is similar to Figure 1, but after the process according to the present invention has been performed;
Figure 3 is similar to Figures 1 and 2, but after the polysilicon layer has been totally removed;
Figure 4 is a schematical cross-sectional view of a reaction chamber used to perform a process according to the present invention.

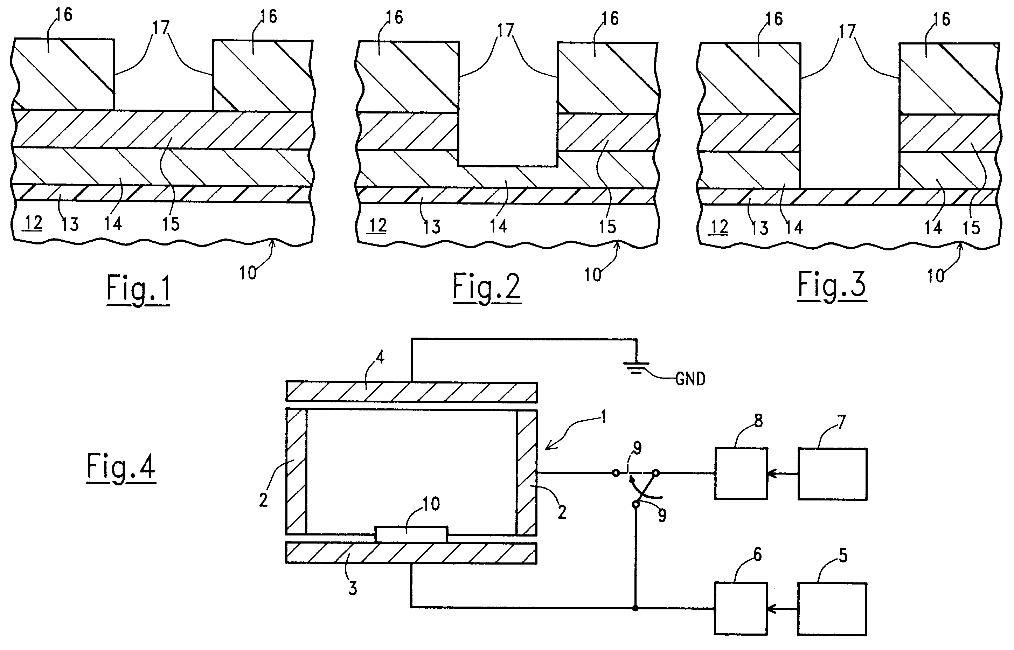

With reference to Figure 4, a reaction chamber 1 is schematically shown of the type conventionally used in microelectronic industry for dry etching processes (specifically plasma etching). The reaction chamber 1 substantially comprises a cilindrical wall 2 closed at its bottom and top ends by two plates 3 and 4, respectively. The reaction chamber 1 also comprises inlet means (per-se known and therefore not shown) at the top plate 4, for supplying gaseous species.

The cilindrical wall 2 and the plates 3 and 4 form three electrodes of the reaction chamber 1, the plates 3 and 4 being electrically isolated from the cilindrical wall 2. A first power supply 5, generating a voltage at a frequency of 100 KHz, is connected through a first matching network 6 to the bottom plate 3 of the reaction chamber; a second power supply 7, generating a voltage at a frequency of 13.56 MHz and supplying a second matching network 8, can be alternatively connected trhough a switch 9 either to the cilindrical wall 2 or to the bottom plate 3. The top plate 4 of the reaction chamber is connected to a common ground GND.

The reaction chamber 1 can be operated in two different triode configurations: in the first configuration, the switch 9 is in the position shown in dash-and-dot line in Figure 4, so that the cilindrical wall 2 is supplied with the voltage at 13.56 MHz; in the second configuration, the switch 9 is in the position shown in continuos line in Figure 4, so that the bottom plate 3 is supplied with both the voltage at 100 KHz and the voltage at 13.56 MHz.

In Figure 1 a cross-section of a part of a wafer 10 to be etched is shown. The process steps leading to the formation of the structure shown in Figure 1 are completely conventional, and provide for: growing a silicon dioxide layer 12 over a silicon substrate 13; depositing a polysilicon layer 14 over the silicon dioxide layer 12; forming a cobalt silicide layer 15 over the polisilicon layer 14; depositing a photoresist layer 16 over the cobalt silicide layer 15 and litographically transferring into it a desired pattern, to open windows 17 in the photoresist layer 16.

At this point, the wafer 10 is introduced into the reaction chamber 1. Chlorine (Cl₂) at a pressure in the range 1-100 mTorr (depending on the specific type of the reaction chamber used) is supplied to the reaction chamber 1. The reaction chamber 1 is operated in the second configuration described above, i.e. with the voltage supply at 13.56 MHz (having a power rating of 200-400 W, corresponding to a power density of 1.6-3.3 W/cm² for a 5 inches wafer) and the voltage supply at 100 KHz (having a power rating of 50-200 W, corresponding to a power density of 0.4-1.6 W/cm²) both connected to the bottom plate 3 of the reaction chamber 1 (switch 9 in the position shown in continuos line in Figure 1). The voltage at 13.56 MHz allows the ionization of chlorine molecules, thus forming a plasma inside the reaction chamber; the voltage at 100 KHz accelerates the ions towards the bottom plate 3. The chlorine ions etch the cobalt silicide layer 15 with a higher etch rate than the photoresist layer 16; thus, the cobalt silicide layer 15 is removed only where it is not covered by the photoresist layer 16, i.e. at the windows 17. This step is ended when the cobalt silicide layer 15 has been completely removed; this situation can be detected by means of laser interferometry or spectroscopy. Actually, at the end of this step, part of the polysilicon layer 14 has also been removed (Fig. 3). The use of plasma etching with chlorine prevents undercuts under the photoresist layer 16, so that the geometry defined in the cobalt silicide layer 15 can be finely controlled.

To complete the process of definition of the interconnection lines, the polysilicon layer 14 is etched in a self-aligned manner with the cobalt silicide layer 15. The reaction chamber 1 is fed with a mixture of chlorine and hidrocloridric acid (HCl), or of chlorine and hidrobromic acid (HBr), typically in a proportion of 1 to 8 by volume. The polysilicon layer 14 is thus completely removed, to uncover the underlying silicon dioxide layer 13 (Fig. 4). The mixture of Cl₂ and HCl is also used to perform over-etching, since it is sufficiently selective not to etch the silicon dioxide layer 13 and not to modify the anisotropy of the etched profile.

## Claims

1. Process for etching a cobalt silicide layer (15), superimposed over a polysilicon layer (14) formed over a silicon substrate (12), and selectively covered by a masking material (16), characterized by submitting the cobalt silicide layer (15) to a flow of gaseous chlorine at a prescribed pressure and ionizing the gaseous chlorine by using a prescribed electrical power to form a plasma for selectively removing the cobalt silicide layer (15).

2. Process according to claim 1, characterized in that said prescribed pressure is in the range 1 - 100 mTorr.

3. Process according to claim 1, characterized in that said prescribed electrical power is in the range 2 - 10 W per square centimeter of surface area of the silicon substrate (12).

4. Process according to claim 1, the polysilicon layer (14) being formed over a silicon dioxide layer (13) superimoosed over said silicon substrate (12), characterized in that it further provides for etching the polysilicon layer (14) in a self-aligned manner with the cobalt silicide layer (15), by submitting the polysilicon layer (14) to a flow of a gaseous mixture of chlorine and hydrocloric acid, and forming a plasma for removing the polysilicon layer (14).
